(19) Europäisches Patentamt
European Patent Office
Office européen des brevets

(11) **EP 1 883 283 B1**

(12) **EUROPEAN PATENT SPECIFICATION**

(45) Date of publication and mention
of the grant of the patent:
**22.02.2012 Bulletin 2012/08**

(51) Int Cl.:
*H05K 1/02* (2006.01)

(21) Application number: **07111270.0**

(22) Date of filing: **28.06.2007**

(54) **Wired Circuit Board**

Leiterplatte

Plaque de circuit imprimé

(84) Designated Contracting States:
**DE FR GB**

(30) Priority: **28.07.2006 JP 2006206642**

(43) Date of publication of application:
**30.01.2008 Bulletin 2008/05**

(73) Proprietor: **NITTO DENKO CORPORATION**
**Ibaraki-shi,**
**Osaka 567-8680 (JP)**

(72) Inventors:
• **Ishii, Jun**
**Ibaraki-shi Osaka 567-8680 (JP)**

• **Yokai, Takahiko**
**Ibaraki-shi Osaka 567-8680 (JP)**

(74) Representative: **Schwabe - Sandmair - Marx**
**Patentanwälte**
**Stuntzstraße 16**
**81677 München (DE)**

(56) References cited:
**EP-A- 1 592 290**     **JP-A- 2005 011 387**
**US-A1- 2004 245 619**     **US-A1- 2005 061 542**

## Description

Field of the Invention

The present invention relates to a wired circuit board and, more particularly, to a wired circuit board such as a suspension board with circuit.

Description of the Related Art

There has been conventionally known a suspension board with circuit in which an insulating layer made of a resin and a conductive pattern made of copper are formed successively on a metal supporting board made of stainless steel.

In such a suspension board with circuit, a transmission loss is large in a conductive pattern since the metal supporting board is made of stainless steel.

To reduce the transmission loss, it is proposed that, e.g., a lower conductor made of a copper alloy is provided on an insulating layer formed on a suspension to be located below the respective conductors of a record-side line and a reproduction-side line each formed by printing (see, e.g., Japanese Unexamined Patent Publication No. 2005-11387).

## SUMMARY OF THE INVENTION

However, in accordance with the proposal mentioned above, the adhesion between the insulating layer and the lower conductor is insufficient and it is difficult to ensure long-term reliability.

It is therefore an object of the present invention to provide a wired circuit board having excellent long-term reliability by improving the adhesion between a first insulating layer and a metal foil, in which a transmission loss can be reduced with a simple layer structure.

A wired circuit board according to the present invention is defined in claim 1 of the appended claims.

It is preferable that the wired circuit board according to the present invention further comprises a second metal thin film formed to be interposed between the metal foil and the second insulating layer.

In the wired circuit board according to the present invention, the metal foil is formed under the conductive pattern. This allows a reduction in transmission loss with a simple layer structure. In addition, the first metal thin film is formed between the first insulating layer and the metal foil. This makes it possible to sufficiently improve the adhesion between the first insulating layer and the metal foil and ensure excellent long-term reliability.

## BRIEF DESCRIPTION OF THE DRAWINGS

FIG. 1 is a cross-sectional view showing a principal portion of a wired circuit board according to an embodiment of the present invention;
FIG. 2 is a production process view showing a method for producing the wired circuit board shown in FIG. 1,

(a) showing the step of preparing a metal supporting board,
(b) showing the step of forming a first insulating base layer on the metal supporting board,
(c) showing the step of forming a first metal thin film on the entire surface of the first insulating base layer,
(d) showing the step of forming a plating resist in a pattern reverse to the pattern of a metal foil on the surface of the first metal thin film, and
(e) showing the step of forming the metal foil on the surface of the first metal thin film exposed from the plating resist;

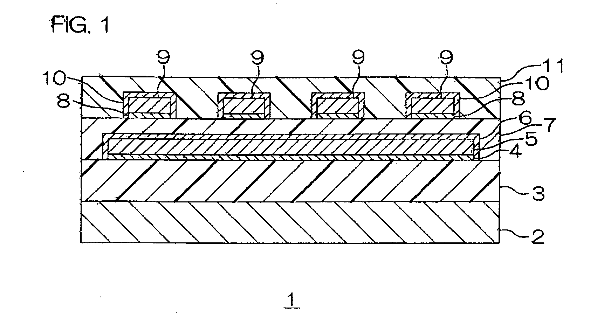

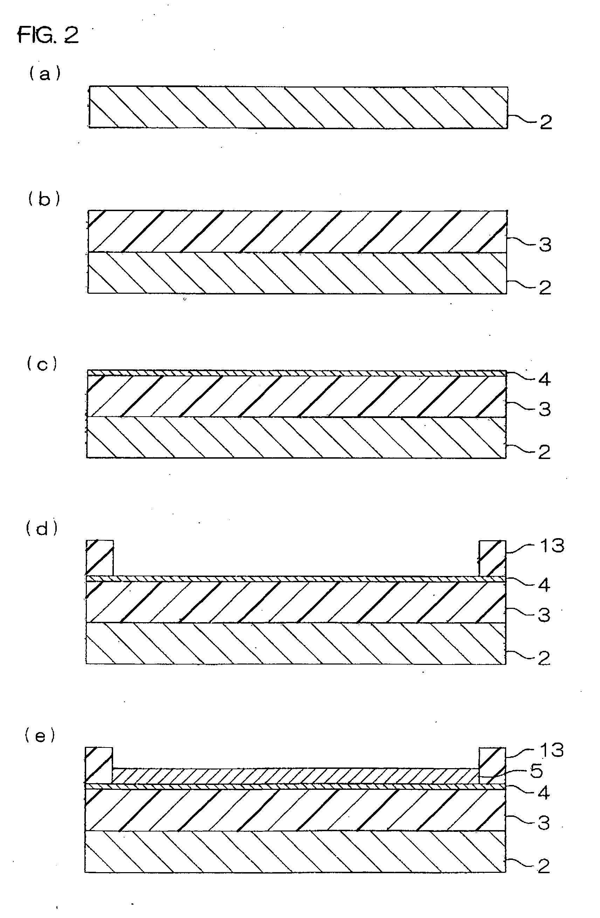

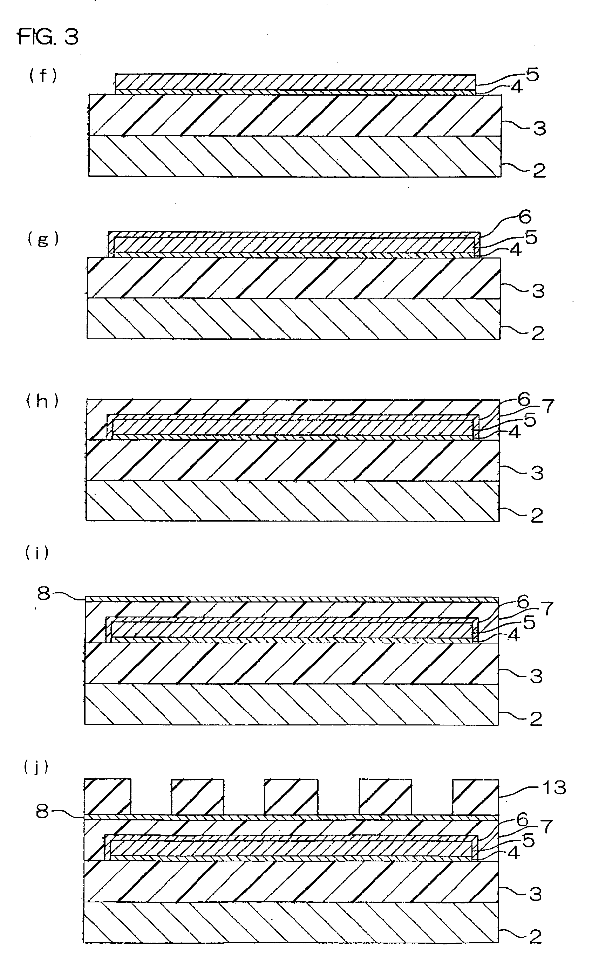

FIG. 3 is a production process view showing the method for producing the wired circuit board shown in FIG. 1, subsequently to FIG. 2,

(f) showing the step of removing the plating resist and the portion of the first metal thin film where the plating resist is formed,
(g) showing the step of forming a second metal thin film on the metal foil and the first insulating base layer to cover the metal foil,
(h) showing the step of forming a second insulating base layer on the first insulating base layer to cover the second metal thin film,

(i) showing the step of forming a third metal thin film on the entire surface of the second insulating base layer, and
(j) showing the step of forming a plating resist in a pattern reverse to a conductive pattern on the surface of the third metal thin film;

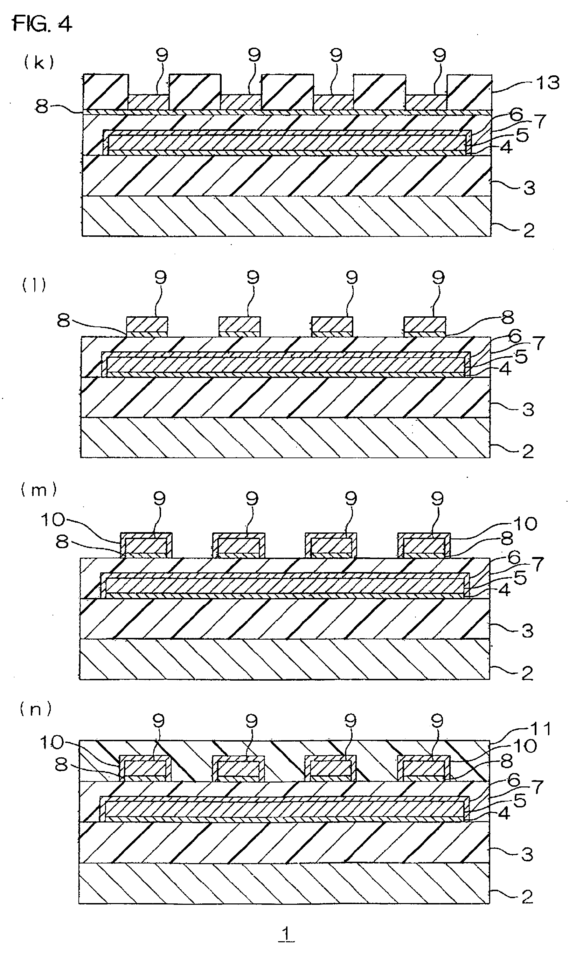

FIG. 4 is a production process view showing the method for producing the wired circuit board shown in FIG. 1, subsequently to FIG. 3,

(k) showing the step of forming the conductive pattern on the surface of the third metal thin film exposed from the plating resist,
(l) showing the step of removing the plating resist and the portion of the third metal thin film where the plating resist is formed,
(m) showing the step of forming a fourth metal thin film on the conductive pattern and the second insulating base layer to cover the conductive pattern, and
(n) showing the step of forming an insulating cover layer on the second insulating base layer to cover the fourth metal thin film; and

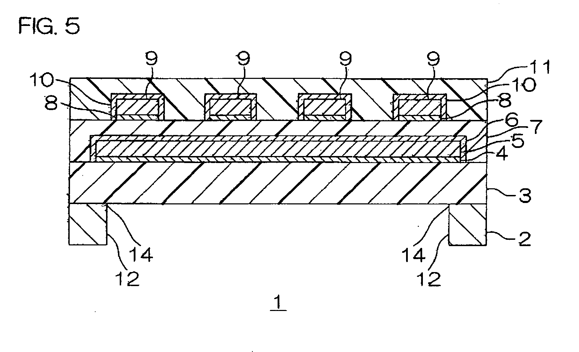

FIG. 5 is a cross-sectional view showing a principal portion of a wired circuit board according to another embodiment of the present invention in which an opening is formed in a metal supporting board.

## DETAILED DESCRIPTION OF THE INVENTION

FIG. 1 is a cross-sectional view showing a principal portion of a wired circuit board according to an embodiment of the present invention.

In FIG. 1, a wired circuit board 1 is a suspension board with circuit mounted on a hard disk drive. The wired circuit board 1 includes a metal supporting board 2 extending in a longitudinal direction, a first insulating base layer 3 formed on the metal supporting board 2, a first metal thin film 4 formed on the first insulating base layer 3, a metal foil 5 formed on the first metal thin film 4, a second metal thin film 6 formed on the first insulating base layer 3 to cover the metal foil 5, a second insulating base layer 7 formed on the first insulating base layer 3 to cover the second metal thin film 6, a third metal thin film 8 formed on the second insulating base layer 7, a conductive pattern 9 formed on the third metal thin film 8, and a fourth metal thin film 10 formed on the second insulating base layer 7 to cover the conductive pattern 9. As necessary, the wired circuit board 1 includes an insulating cover layer 11 formed on the second insulating base layer 7 to cover the fourth metal thin film 10.

The metal supporting board 2 is composed of a metal foil in the shape of a flat plate or of a metal thin plate. Examples of a metal used to form the metal supporting board 2 include stainless steel and a 42-alloy. Preferably, stainless steel is used. The thickness of the metal supporting board 2 is in the range of, e.g., 15 to 30 $\mu$m, or preferably 20 to 25 $\mu$m.

The first insulating base layer 3 is formed on a surface of the metal supporting board 2. More specifically, the first insulating base layer 3 is formed on the entire surface of the metal supporting board 2 in the widthwise direction (orthogonal to the longitudinal direction). Examples of an insulating material used to form the first insulating base layer 3 include synthetic resins such as polyimide, polyether nitrile, polyether sulfone, polyethylene terephthalate, polyethylene naphthalate, and polyvinyl chloride, each of which is typically used as an insulating material for a wired circuit board. Among them, a photosensitive synthetic resin is preferably used, or more preferably, photosensitive polyimide is used. The thickness of the first insulating base layer 3 is in the range of, e.g., 1 to 10 $\mu$m, or preferably 1 to 5 $\mu$m.

The first metal thin film 4 is formed in a pattern on the surface of the first insulating base layer 3 to correspond to a portion where the metal foil 5 is formed. More specifically, the first metal thin film 4 is formed between the two widthwise outermost wires of a plurality of (four) wires arranged in widthwise mutually spaced-apart relation as is described later, to oppose to these wires in a thickness direction and have a width smaller than that of the first insulating base layer 3. Examples of a metal used to form the first metal thin film 4 include copper, chromium, gold, silver, platinum, nickel, titanium, silicon, manganese, zirconium, an alloy thereof, and an oxide thereof, or preferably, copper, chromium, nickel, or an alloy thereof is used. The first metal thin film 4 may also be composed of a plurality of layers. The thickness of the first metal thin film 4 is in the range of, e.g., 0.01 to 1 $\mu$m, or preferably 0.01 to 0.1 $\mu$m.

The metal foil 5 is formed in a pattern on the surface of the first metal thin film 4 to correspond to at least a portion where the conductive pattern 8 is formed. More specifically, the metal foil 5 is formed on the entire surface of the first metal thin film 4 in the widthwise direction. As a metal for forming the metal foil 5, copper is preferably used. The thickness of the metal foil 5 is in the range of, e.g., 0.1 to 5 $\mu$m, or preferably 1 to 5 $\mu$m.

The second metal thin film 6 is formed on the surface of the metal foil 5 to cover the metal foil 5. More specifically, the second metal thin film 6 is formed continuously to cover the upper surface and both widthwise side surfaces of the metal foil 5 and the both widthwise side surfaces of the first metal thin film 4. The second metal thin film 6 is formed to be interposed between the second insulating base layer 7 and both of the metal foil 5 and the first metal thin film 4.

Examples of a metal used to form the second metal thin film 6 include nickel, chromium, and an alloy (nichrome) of nickel and chromium. Preferably, nickel is used. The thickness of the second metal thin film 6 is in the range of, e.g., 0.01 to 1 $\mu$m, or preferably 0.01 to 0.1 $\mu$m.

The second insulating base layer 7 is formed on the first insulating base layer 3 to cover the second metal thin film 6. To form the second insulating baser layer 7, any of the same insulating materials is used as that used to form the first insulating base layer 3 mentioned above. Preferably, a photosensitive synthetic resin is used, or more preferably, photosensitive polyimide is used. The thickness of the second insulating base layer 7 is in the range of, e.g., 1 to 15 $\mu$m, or preferably 8 to 12 $\mu$m.

The third metal thin film 8 is formed in a pattern on the surface of the second insulating base layer 7 to correspond to a portion where the conductive pattern 9 is formed. To form the third metal thin film 8, any of the same metals is used as that used to form the first metal thin film 4 mentioned above. Preferably, copper, chromium, or nickel is used. The thickness of the third metal thin film 8 is in the range of, e.g., 0.01 to 1 $\mu$m, or preferably 0.01 to 0.1 $\mu$m.

The conductive pattern 9 is formed as a wired circuit pattern composed of a plurality of (e.g., four) wires provided on the surface of the third metal thin film 8 to be arranged in a widthwise mutually spaced-apart and longitudinally parallel relation, and of terminal portions provided on both longitudinal end portions of the respective wires, though not shown. Examples of a conductive material used to form the conductive pattern 9 include metals such as copper, nickel, gold, a solder, and an alloy thereof. Among them, copper is preferably used. The thickness of the conductive pattern 9 is in the range of, e.g., 5 to 20 $\mu$m, or preferably 7 to 15 $\mu$m. The width of each of the wires is in the range of, e.g., 15 to 100 $\mu$m, or preferably 20 to 50 $\mu$m. The spacing between the individual wires is in the range of, e.g., 15 to 100 $\mu$m, or preferably 20 to 50 $\mu$m.

The fourth metal thin film 10 is formed on the surface of the conductive pattern 9 to cover the conductive pattern 9. More specifically, the fourth metal thin film 10 is formed continuously to cover the upper surface (except for the upper surfaces of the terminal portions) and both widthwise side surfaces of the wires of the conductive pattern 9, and both the widthwise side surfaces of the third metal thin film 8. The fourth metal thin film 10 is formed to be interposed between the insulating cover layer 11 and each of the conductive pattern 9 and the third metal thin film 8.

To form the fourth metal thin film 10, any of the same metals is used as that used to form the second metal thin film, or preferably, nickel is used. The thickness of the fourth metal thin film 10 is in the range of, e.g., 0.01 to 1 $\mu$m, or preferably 0.01 to 0.1 $\mu$m.

The insulating cover layer 11 is formed on the second insulating base layer 7 to cover the fourth metal thin film 10. More specifically, the insulating cover layer 11 is formed on the entire surface in the widthwise direction of the second insulating base layer 7. To form the insulating cover layer 11, any of the same insulating materials is used as that used to form the first insulating base layer 3 mentioned above. Preferably, a photosensitive synthetic resin is used, or more preferably, photosensitive polyimide is used. The thickness of the insulating cover layer 11 is in the range of, e.g., 2 to 10 $\mu$m, or preferably 3 to 6 $\mu$m. The insulating cover layer 11 has openings formed to expose the terminal portions of the conductive pattern 9, though not shown.

Next, a description is given to a method for producing the wired circuit board 1 with reference to FIGS. 2 to 4.

First, as shown in FIG. 2(a), the metal supporting board 2 is prepared in the method.

Next, as shown in FIG. 2(b), a solution (varnish) of, e.g., the synthetic resin mentioned above is uniformly coated on the surface of the metal supporting board 2, dried, and then heated to be cured as necessary to form the first insulating base layer 3 made of the synthetic resin. Alternatively, the first insulating base layer 3 may also be formed in a pattern by coating a photosensitive synthetic resin, drying, exposing to light, and developing the resin. The formation of the first insulating base layer 3 is not particularly limited to the methods shown above. For example, it is also possible to preliminarily form a synthetic resin into a film and then stick the film to the surface of the metal supporting board 2 via a known adhesive layer.

Next, as shown in FIG. 2(c), the first metal thin film 4 is formed on the entire surface of the first insulating base layer 3.

The first metal thin film 4 is formed by electrolytic plating, electroless plating, sputtering, or the like.

For electrolytic plating, a method is used in which, e.g., a (primary) surface-treated wired circuit board 1 in a process of the production shown in FIG. 2(b) is dipped in a plating solution of any of the metals shown above to conduct for a predetermined time in the plating solution. Preferably, an electrolytic nickel plating is used in which the wired circuit board 1 in a process of the production shown in FIG. 2(b) is dipped in a nickel plating solution to conduct in the plating solution.

For electroless plating, a method is used in which a (catalytically) surface-treated wired circuit board 1 in a process of the production shown in FIG. 2(b) is dipped in a plating solution of any of the metals shown above for a predetermined time. Preferably, an electroless nickel plating is used in which the wired circuit board 1 in a process of the production shown in FIG. 2(b) is dipped in a nickel plating solution for a predetermined time.

For sputtering, a method is used in which any of the metals shown above is sputtered as a target. Preferably, chromium sputtering and copper sputtering are used, whereby a chromium thin film and a copper thin film are successively laminated.

Next, as shown in FIG. 2(d), a plating resist 13 is formed in a pattern reverse to the pattern of the metal foil 5 described above on the surface of the first metal thin film 4. For the formation of the plating resist 13, a known method is used in which, e.g., a dry film resist is provided, exposed to light, and developed.

Next, as shown in FIG. 2(e), the metal foil 5 is formed on the surface of the first metal thin film 4 exposed from the plating resist 13 by electrolytic plating, or preferably electrolytic copper plating, using the plating resist 13 as a plating resist.

Next, as shown in FIG. 3(f), the plating resist 13 and the portion of the first metal thin film 4 where the plating resist 13 is formed are removed by, e.g., a known etching method such as chemical etching (wet etching) or by stripping.

Next, as shown in FIG. 3(g), the second metal thin film 6 is formed continuously to cover the upper surface and both widthwise side surfaces of the metal foil 5, and both the widthwise side surfaces of the first metal thin film 4.

The second metal thin film 6 is formed by electrolytic plating, electroless plating, sputtering, or the like. Preferably, the second metal thin film 6 is formed by electroless plating.

In the electroless plating, the (catalytically) surface-treated wired circuit board 1 shown in a process of the production shown in FIG. 3(f) is dipped for a predetermined time in a plating solution of any of the metals shown above, or preferably a nickel plating solution, whereby the second metal thin film 6 made of nickel is formed.

Next, as shown in FIG. 3(h), the same synthetic resin solution (varnish) as that used to form, e.g., the first insulating base layer 3 is uniformly coated on the entire surface of the first insulating base layer 3 including the second metal thin film 6. The coating is then dried and heated to be cured as necessary to form the second insulating base layer 7 made of the synthetic resin. Alternatively, the second insulating base layer 7 may also be formed in a pattern by coating a photosensitive resin, drying, exposing to light, and then developing the resin. The formation of the second insulating base layer 7 is not particularly limited to the methods shown above. For example, it is also possible to preliminarily form a synthetic resin into a film and then stick the film to the surface of the first insulating base layer 3 including the second metal thin film 6 via a known adhesive layer.

Next, as shown in FIGS. 3(i) to 4(l), the third metal thin film 8 (seed film) and the conductive pattern 9 are formed successively on the second insulating base layer 7 by a patterning method such as an additive method.

Specifically, in the additive method, the third metal thin film 8 (seed film) is formed first on the entire surface of the second insulating base layer 7.

The third metal thin film 8 is formed by electrolytic plating or sputtering, or preferably by sputtering. More preferably, the third metal thin film 8 is formed by successively laminating a chromium thin film and a copper thin film by chromium sputtering and copper sputtering.

Next, as shown in FIG. 3(j), a dry film resist is provided on the surface of the third metal thin film 8, exposed to light, and then developed to form the plating resist 13 in a pattern reverse to the wired circuit pattern. Then, as shown in FIG. 4(k), the conductive pattern 9 is formed in the wired circuit pattern by plating on the surface of the third metal thin film 8 exposed from the plating resist 13. Then, as shown in FIG. 4(l), the plating resist 13 and the portion of the third metal thin film 8 where the plating resist 13 is formed are removed by etching or the like. The plating may be either electrolytic plating or electroless plating. Preferably, electrolytic plating is used, or more preferably, electrolytic copper plating is used.

Next, as shown in FIG. 4(m), the fourth metal thin film 10 is formed continuously on the upper surface and both widthwise side surfaces of the conductive pattern 9, and on both the widthwise side surfaces of the third metal thin film 8 to cover the conductive pattern 9 and the third metal thin film 8.

The fourth metal thin film 10 is formed in the same manner as in the method for forming the second metal thin film 6. Preferably, the fourth metal thin film 10 made of nickel is formed by an electroless nickel plating method in which the (catalytically) surface-treated wired circuit board 1 in a process of the production shown in FIG. 4(l) is dipped in a nickel plating solution for a predetermined time.

Next, as shown in FIG. 4(n), the solution of any of the synthetic resins mentioned above, e.g., is uniformly coated on the second insulating base layer 7 to cover the fourth metal thin film 10. The coating is then dried and heated to be cured as necessary to form the insulating cover layer 11 made of the synthetic resin, whereby the wired circuit board 1 is obtained.

Alternatively, the insulating cover layer 11 may also be formed in a pattern by coating a photosensitive synthetic resin, drying, exposing to light, and developing the resin. The formation of the insulating cover layer 11 is not particularly limited to the methods shown above. For example, it is also possible to preliminarily form the synthetic resin into a film and stick the film to the surface of the second insulating base layer 7 to cover the fourth metal thin film 10 via a known adhesive layer.

The insulating cover layer 11 is formed to expose the terminal portions, not shown, of the conductive pattern 9. To expose the terminal portions of the conductive pattern 9, the insulating cover layer 11 is formed in a pattern using the photosensitive synthetic resin mentioned above or by a boring process using a laser or a punch.

Thereafter, the fourth metal thin film 10 formed on the upper surfaces of the terminal portions of the conductive pattern 9 is removed by etching or the like. Then, the metal supporting board 2 is trimmed into a desired shape to provide the suspension board with circuit.

In the wired circuit board 1, the metal foil 5 is formed under the conductive pattern 9 to oppose thereto. This allows a reduction in transmission loss with a simple layer structure. In addition, the first metal thin film 4 is formed to be interposed between the first insulating base layer 3 and the metal foil 5. This makes it possible to sufficiently improve the adhesion between the first insulating base layer 3 and the metal foil 5 and ensure excellent long-term reliability.

The wired circuit board 1 further includes the second metal thin film 6 formed to be interposed between the metal foil 5 and the second insulating base layer 7. When the second insulating base layer 7 is formed directly on the surface of the metal foil 5, the phenomenon of ion migration occurs in which the metal of the metal foil 5 migrates to the second insulating base layer 7. However, by interposing the second metal thin film 6 between the metal foil 5 and the second insulating base layer 7, the second metal thin film 6 serving as a barrier layer can prevent the occurrence of the phenomenon of ion migration.

For the adjustment of the characteristic impedance, an opening 12 can also be formed in the wired circuit board 1 by cutting out the metal supporting board 2 into a desired shape by etching, as shown in FIG. 5. In this case, the end opening edge 14 of the opening 12 in the metal supporting board 2 is in direct contact with the first insulating base layer 3. This allows an improvement in the adhesion of the end opening edge 14 of the opening 12 to the metal supporting board 2. As a result, it is possible to effectively prevent the metal supporting board 2 from peeling, while allowing the adjustment of the characteristic impedance of the conductive pattern 5 and a reduction in transmission loss.

As described above, even when the opening 12 is formed in the metal supporting board 2 by etching, the first insulating base layer 3 is formed under the first metal thin film 5 in the opening 12. As a result, it is possible to prevent the elimination (peeling) of the metal from the first metal thin film 4 caused by etching to result in preventing scattering of the eliminated metal as a foreign substance.

In the method for producing the wired circuit board 1 described above, the conductive pattern 9 is formed by the additive method, as shown in FIGS. 3(i) to 4(l). However, the formation of the conductive pattern 9 is not limited to the method shown above. For example, it is also possible to form the conductive pattern 9 in the wired circuit pattern by a known patterning method such as a subtractive method. In the case where the conductive pattern 9 is formed by the subtractive method, the conductive pattern 9 is formed directly on the surface of the second insulating base layer 7 without forming the third metal thin film 8.

To form the conductive pattern 9 by the subtractive method, e.g., a conductive layer is formed first on the entire surface of the second insulating base layer 7, though not shown. The formation of the conductive layer is not particularly limited. For example, the conductive layer is sticked to the entire surface of the second insulating base layer 7 via a known adhesive layer. Then, a dry film resist is provided on the surface of the conductive layer, exposed to light, and developed to form an etching resist in the same pattern as the wired circuit pattern. Thereafter, the conductive layer exposed from the etching resist is removed by etching (wet etching) and then the etching resist is removed.

EXAMPLES

The present invention is described more specifically by showing the examples and the comparative examples herein below. However, the present invention is by no means limited to the examples and the comparative examples.

EXAMPLE 1

A metal supporting board made of stainless steel having a thickness of 25 $\mu$m was prepared first (see FIG. 2 (a)). A varnish of a photosensitive polyamic acid resin was coated on the surface of the metal supporting board, dried, exposed to light, developed, and further heated to be cured to form a first insulating base layer made of polyimide having a thickness of 10 $\mu$m in the foregoing pattern (see FIG. 2(b)).

Then, a chromium thin film having a thickness of 0.03 $\mu$m and a copper thin film having a thickness of 0.07 $\mu$m were successively laminated on the entire surface of the first insulating base layer by chromium sputtering and copper sputtering to form a first metal thin film (see FIG. 2(c)). Then, a plating resist was formed in the foregoing pattern reverse to the pattern of a metal foil by providing a dry film resist on the surface of the first metal thin film, exposing it to light, and developing it (see FIG. 2(d)). Subsequently, a copper foil having a thickness of 4.0 $\mu$m was formed as the metal foil on the surface of the first metal thin film exposed from the plating resist by electrolytic copper plating (see FIG. 2(e)). Thereafter, the plating resist and the portion of the first metal thin film where the plating resist was formed were removed by chemical etching (see FIG. 3(f)).

Then, a nickel thin film having a thickness of 0.1 $\mu$m was formed continuously as a second metal thin film on the upper surface and both widthwise side surfaces of the metal foil and on both the widthwise side surfaces of the first metal thin film to cover the metal foil and the first metal thin film (see FIG. 3(g)).

Then, a varnish of a photosensitive polyamic acid resin was coated on the entire surface of the first insulating base layer including the second metal thin film, dried, exposed to light, developed, and further heated to be cured to form a second insulating base layer made of polyimide having a thickness of 10 $\mu$m in the foregoing pattern (see FIG. 3(h)).

Then, a third metal thin film serving as a seed film and a conductive pattern were formed successively on the second insulating base layer by an additive method (see FIGS. 3(i) to 4(l)).

In the additive method, a chromium thin film having a thickness of 0.03 um and a copper thin film having a thickness of 0.07 $\mu$m were formed successively on the entire surface of the second insulating base layer by chromium sputtering and copper sputtering to serve as the third metal thin film (see FIG. 3(i)). Subsequently, a plating resist was formed in a pattern reverse to the conductive pattern by providing a dry film resist on the surface of the third metal thin film, exposing it to light, and developing it (see FIG. 3(j)). Then, a conductive pattern having a thickness of 10 $\mu$m was formed on the surface of the third metal thin film exposed from the plating resist by electrolytic copper plating (see FIG. 4(k)). Then, the plating resist and the portion of the third metal thin film where the plating resist was formed were removed by chemical etching (see FIG. 4(l)).

Then, as a fourth metal thin film, a nickel thin film having a thickness of 0.1 $\mu$m was formed continuously on the upper surface and both widthwise side surfaces of the conductive pattern and on both the widthwise side surfaces of the third metal thin film by electroless nickel plating to cover the conductive pattern and the third metal thin film (see FIG. 4(m)).

Then, a varnish of a photosensitive polyamic acid resin was coated to cover the fourth metal thin film, dried, exposed to light, developed, and further heated to be cured to form an insulating cover layer made of polyimide having a thickness of 5 $\mu$m in a pattern to cover the fourth metal thin film (except for the portions where the terminal portions were formed) on the surface of the second insulating base layer (see FIG. 4(n)). Thereafter, the fourth metal thin film formed on the upper surfaces of the terminal portions was removed by etching and then the metal supporting board was cut out into a desired shape by etching to provide a suspension board with circuit.

EXAMPLE 2

A suspension board with circuit was obtained in the same manner as in EXAMPLE 1 except that the second insulating base layer was formed on the first insulating base layer to cover the upper surface and both widthwise side surfaces of the metal foil and both the widthwise side surfaces of the first metal thin film without forming the second metal thin film.

COMPARATIVE EXAMPLE 1

A suspension board with circuit was obtained in the same manner as in EXAMPLE 1 except that the metal foil was formed directly on the surface of the first insulating base layer without forming the first metal thin film.

The metal foil was formed by a subtractive method, more specifically, by sticking a metal layer to the entire surface of the first insulating base layer via an adhesive layer, providing a dry film resist on the surface of the metal layer, exposing it to light, and developing it to form an etching resist in the same pattern as that of the metal foil, performing wet etching with respect to the metal layer exposed from the etching resist, and then removing the etching resist.

COMPARATIVE EXAMPLE 2

A suspension board with circuit was obtained in the same manner as in EXAMPLE 1 except that the first metal thin film, the metal foil, the second metal thin film, and the second insulating base layer were not formed.

That is, the suspension board with circuit was obtained in the same manner as in EXAMPLE 1 except that the third metal thin film was formed directly on the entire surface of the first insulating base layer.

(Evaluation)

(1) Evaluation of Transmission Efficiency

In each of the suspension boards with circuit obtained in the examples and the comparative examples, an output signal intensity ($P_{OUT}$) and an input signal intensity ($P_{IN}$) were measured and the transmission efficiency was evaluated as the ratio of the output signal intensity to the input signal intensity given by Formula (1) shown below. The result of the evaluation is shown in Table 1.

$$\text{Transmission Efficiency (\%)} = P_{OUT}/P_{IN} \qquad \ldots (1)$$

.

(2) Evaluation of Adhesion

Each of the suspension boards with circuit obtained in EXAMPLES 1 and 2, and COMPARATIVE EXAMPLE 1 was allowed to stand under temperature conditions of -40°C and 120 °C in one cycle. For each of the suspension boards with circuit, the adhesion between the first insulating layer and the metal foil after 1000 cycles was evaluated based on the tape peeling. The result of the evaluation is shown in Table 1.

(3) Evaluation of Phenomenon of Ion migration

After using each of the suspension boards with circuit obtained in EXAMPLES 1 and 2 for 1000 hours at a temperature of 85 °C, at a humidity of 85%, and with the application of a 10 V voltage, the phenomenon of ion migration was examined in which the copper of the copper foil as the metal foil migrated to the surface or inside of polyimide as the first insulating base layer. As a result, the phenomenon was not observed in EXAMPLE 1 in which the second metal thin film served as a barrier layer. By contrast, the phenomenon of ion migration of the copper of the copper foil to the surface or inside of polyimide was observed in EXAMPLE 2 and the discoloration of polyimide was observed.

Table 1

Table 1

|  | EXAMPLE 1 | EXAMPLE 2 | COMPARATIVE EXAMPLE 1 | COMPARATIVE EXAMPLE 2 |
|---|---|---|---|---|
| Transmission Efficiency ($P_{OUT}/P_{IN}$) (%) | 79.3 | 79.5 | 79.1 | 55.0 |
| Adhesion (Long-Term Reliability)* | Excellent | Excellent | Poor | - |
| *Evaluation (Excellent: Tape Peeling was Not Observed, Poor: Tape Peeing was Observed) | | | | |

## Claims

1.  A wired circuit board (1) comprising:

    a metal supporting board (2);
    a first insulating layer(3) formed on the metal supporting board (2);
    a second insulating layer (7) formed on the first insulating layer (3) to cover a metal foil (5); and
    a conductive pattern (9) formed on the second insulating layer (7),
    **characterized in that**:

    the wired circuit board (1) further comprises:

    a first metal thin film (4) formed on the first insulating layer (3);
    wherein the metal foil (5) is formed on the first metal thin film (4);
    wherein the metal supporting board (2) comprises an opening (12) formed under the first metal thin film (4); and
    wherein the first metal thin film (4) is covered by the first insulating layer (3) along the entire width direction of the opening (12).

2.  The wired circuit board (1) according to claim 1, further comprising:

    a second metal thin film (6) formed to be interposed between the metal foil (5) and the second insulating layer (7).

## Patentansprüche

1.  Verdrahtete Schaltungsplatte bzw. Leiterplatte (1), die aufweist:

    eine metallische Stützplatte (2);
    eine erste Isolierschicht (3), die auf der metallischen Stützplatte (2) ausgebildet ist;
    eine zweite Isolierschicht (7), die auf der ersten Isolierschicht (3) ausgebildet ist, um eine Metallfolie (5) abzudecken; und
    ein leitendes Muster (9), das auf der zweiten Isolierschicht (7) ausgebildet ist,

**dadurch gekennzeichnet, dass**:

die verdrahtete Schaltungsplatte bzw. Leiterplatte (1) weiter aufweist:

eine erste metallische Dünnschicht bzw. dünne Folie (4), die auf der ersten Isolierschicht (3) ausgebildet ist;

wobei die Metallfolie (5) auf der ersten metallischen Dünnschicht bzw. dünnen Folie (4) ausgebildet ist;

wobei die metallische Stützplatte (2) eine Öffnung (12) aufweist, die unter der ersten metallischen Dünnschicht bzw. dünnen Folie (4) ausgebildet ist; und

wobei die erste metallische Dünnschicht bzw. dünne Folie (4) durch die erste Isolierschicht (3) entlang der gesamten Breitenrichtung der Öffnung (12) abgedeckt ist.

2. Verdrahtete Schaltungsplatte bzw. Leiterplatte (1) nach Anspruch 1, weiter aufweisend:

eine zweite metallische Dünnschicht bzw. dünne Folie (6), die ausgebildet ist, um zwischen der Metallfolie (5) und der zweiten Isolierschicht (7) dazwischen zu liegen.

**Revendications**

1. Carte de circuit câblé (1) comprenant :

une carte de support métallique (2) ;
une première couche isolante (3) formée sur la carte de support métallique (2) ;
une seconde couche isolante (7) formée sur la première couche isolante (3) pour couvrir une feuille métallique (5) ; et
un motif conducteur (9) formé sur la seconde couche isolante (7),
**caractérisé en ce que** :

la carte de circuit câblé (1) comprend en outre :

un premier film mince métallique (4) formé sur la première couche isolante (3) ;
dans lequel la feuille métallique (5) est formée sur la première couche mince métallique (4) ;
dans lequel la carte de support métallique (2) comprend une ouverture (12) formée sous le premier film mince métallique (4) ; et
dans lequel le premier film mince métallique (4) est couvert par la première couche isolante (3) sur toute la largeur de l'ouverture (12).

2. Carte de circuit câblé (1) selon la revendication 1, comprenant en outre :

un second film mince métallique (6) formé pour être interposé entre la feuille métallique (5) et la seconde couche isolante (7).

FIG. 1

1

FIG. 2

(a)

(b)

(c)

(d)

(e)

## FIG. 3

(f)

(g)

(h)

(i)

(j)

FIG. 4

(k)

(l)

(m)

(n)

1

FIG. 5

**EP 1 883 283 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005011387 A